# FASCICULE DE BREVET EUROPEEN

(11) **EP 1 916 567 B1**
(45) Date de publication et mention de la délivrance du brevet: **07.04.2010**
(21) Numéro de dépôt: 06124603.9
(22) Date de dépôt: 22.11.2006
(51) Int. Cl.: G03F 7/00

(54) **Méthode de fabrication mixte de pièces par photolithographie, ajouts d'inserts et électroformage**
Verfahren zur Mischfertigung von Teilen für die Photolithographie, Einsatzteile und die Galvanoformung
Mixed manufacturing method for parts by photolithography, adding inserts and electroforming

(30) Priorité: 26.10.2006 EP 06123024
(43) Date de publication de la demande: 30.04.2008
(73) Titulaire: Mimotec S.A., 1950 Sion (CH)
(72) Inventeur: Lorenz, Hubert, 1965, Granois (Savièse) (CH); Genolet, Grégoire, 1920, Martigny (CH); Glassey, Marc-André, 1967, Bramois (CH)
(74) Mandataire: Leman Consulting S.A.

(56) Documents cités:
- US-A- 3 876 511
- HO C-H ET AL: "Ultrathick SU-8 mold formation and removal, and its application to the fabrication of LIGA-like micromotors with embedded roots" SENSORS AND ACTUATORS A, ELSEVIER SEQUOIA S.A., LAUSANNE, CH, vol. 102, no. 1-2, 1 décembre 2002 (2002-12-01), pages 130-138, XP004393669 ISSN: 0924-4247

## Description

### Introduction

La présente demande concerne le domaine de la fabrication de micro-structures par électroformage en particulier des micro-structures permettant de fabriquer des pièces mettant en oeuvre plusieurs composants.

### Etat de la technique

Le procédé de fabrication de micro-composants par irradiation d'une couche photosensible aux rayons ultraviolets suivie d'une étape d'électroformage est connu et est décrit par exemple dans la demande de brevet numéro EP 0 851 295.

Ce procédé est dérivé de la technique LIGA (Lithographie Galvanoformung Abformung) et consiste à:
- déposer sur un substrat une couche de 1 à 2000 µm d'une résine photosensible (photoresist);
- effectuer à travers un masque une irradiation au moyen d'un synchrotron ou par une exposition de rayons ultraviolets;
- développer, c'est-à-dire éliminer par des moyens chimiques les portions de photoresist non polymérisées et créer de ce fait une cavité en photoresist.
- électroformer un métal dans cette cavité afin d'obtenir le composant micromécanique.

L'avantage de cette technique est de réaliser des composants d'une très grande précision en X et Y et avec une épaisseur allant jusqu'à plusieurs millimètres. Il est également possible d'appliquer ce procédé en plusieurs étapes pour obtenir un composant en plusieurs niveaux, chaque niveau étant construit sur le précédent.

Ce procédé est décrit plus avant dans la demande EP 1225477 et détaille le processus de masquage, d'irradiation et de dissolution de la partie non irradiée.

Cette technique est bien connue pour la fabrication de pièces pour l'horlogerie tels que par exemple des roues dentées, des cames, bascules ou ponts.

Une fois cette pièce produite par électroformage, elle est ensuite travaillée par un horloger pour y ajouter les inserts nécessaires tels que les pierres, paliers, galets et autres axes.

La particularité de ces inserts est de n'être par réalisable par électroformage, soit pour des raisons de matière (pierre, rubis), soit pour des raisons de traitement de surface (trempage par exemple).

C'est pourquoi ces inserts sont rapportés sur la pièce semi-finie par l'horloger, par enchâssement, sertissage, vissage ou autre emboutissage.

Ces opérations sont délicates du fait de la petitesse des pièces en jeu et les faibles portée de soutien. Il arrive que lors de la pose d'une pierre, on détériore toute la pièce et les pierres déjà posées par un geste malheureux.

A chaque opération, on ajoute de plus une imprécision résultant des tolérances de l'insert et de la pièce.

Une solution pour l'assemblage d'éléments décoratifs sur un substrat en utilisant une étape d'électroformage est décrite dans le brevet US 3 876 511. Des éléments décoratifs sont posés sur la pièce à décorer et l'assemblage de ces éléments sur le support est effectué par électroformage, c'est-à-dire par une dépose d'une couche métallique.

Il s'agit de la formation d'éléments décoratifs sur la base d'une pièce mécanique telle qu'un cadran de montre par exemple. Le positionnement des éléments décoratifs est approximatif et convient bien à une fonction purement esthétique.

Le document EP 1 835 339 décrit la fabrication de pièces de précision grâce à la technique LIGA. Un moule en photoresist est utilisé pour définir les contours de la pièce et une opération d'électroformage permet de réaliser la pièce par croissance métallique. Pour réaliser des pas de vis, il est prévu d'introduire dans le substrat une vis en matière non métallique, la croissance métallique autour de cette vis permettant la formation d'un filetage, une fois la vis retirée.

### Brève description de l'invention

Ainsi, un des buts de la présente invention est de supprimer les opérations subséquentes pour l'obtention de pièces nécessitant au moins l'assemblage de deux éléments, l'un obtenu par électroformage, et l'autre par un autre procédé de fabrication.

Ce but est atteint par une méthode de fabrication de pièces nécessitant au moins l'assemblage de deux éléments, l'un obtenu par électroformage, et l'autre par un autre procédé de fabrication, cette méthode comprenant les étapes suivantes :
- irradiation au travers d'un premier photomasque, d'une première couche de photorésist appliquée sur un substrat définissant un premier niveau,
- polymérisation de la première couche de photorésist et élimination de la couche de photorésist non polymérisée, la partie de photorésist restante
- constituant le moule photorésist,
- placement d'un élément rapporté obtenu par un autre procédé de fabrication dans le moule photorésist, ledit moule de photoresist servant de guide à l'élément rapporté,
- dépôt d'un couche métallique par électro-formage sur le substrat de sorte que la croissance de la couche métallique enserre tout ou partie de l'élément rapporté,
- obtention de la pièce par séparation du substrat d'avec la couche métallique électroformée solidaire de l'élément rapporté et élimination du moule photorésist.

La présente demande concerne également un produit fini sous la forme d'une pièce composée de deux éléments, soit un premier élément composé par une partie métallique obtenue par photolithographie et électroformage, et un second élément composé d'un ou plusieurs éléments rapportés obtenus par un autre procédé de fabrication et comprenant au moins un flanc en contact avec la partie métallique, la liaison entre l'élément rapporté et la partie métallique est dite intime résultant de la croissance de la partie métallique le long du flanc de l'élément rapporté, tout ou partie des deux faces de la pièce sont constituées par la partie métallique, et caractérisée en ce que le ou les éléments rapportés sont guidés par le moule de photorésist.

Grâce à la méthode décrite ci-dessus, la pièce finale sortant de l'électroformage comprend le ou les éléments rapportés en son sein.

La croissance métallique sur le substrat va enserrer l'élément rapporté, par exemple une pierre et elle fera ainsi partie de la pièce finale. La couche de photoresist a pour but de positionner l'élément rapporté avant la phase de dépôt de métal. L'indexation entre la pièce métallique électroformée et l'élément rapporté est parfait car le même moule qui défini la pièce électroformée définit également la position de référence de l'élément rapporté.

### Brève description des figures

L'invention sera mieux comprise grâce à la description détaillée qui va suivre en se référant aux dessins annexés dans lesquels :
- la figure 1 illustre un substrat avec sa couche de photoresist,
- la figure 2 illustre l'exposition du photoresist au travers d'un masque,
- la figure 3 illustre la cavité en photoresist après développement
- la figure 4 illustre le placement d'un élément rapporté sur la moule,
- la figure 5 illustre la pièce dans le moule de photoresist,
- la figure 6 illustre la pièce une fois le moule dissous,
- les figures 6a à 6h et 6j à 6k illustrent les différentes variantes de l'invention,
- les figures 7 à 11 illustrent quelques exemples de réalisation.

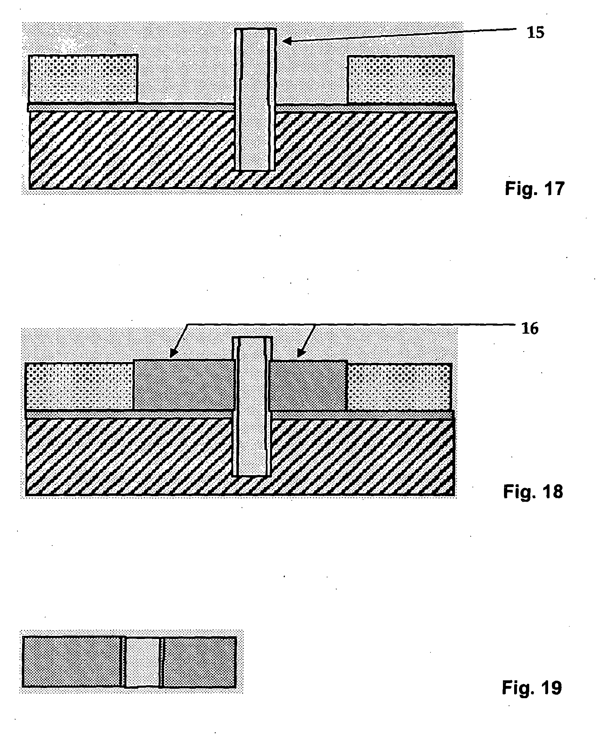

- Les figures 12 à 19 illustrent un autre exemple de réalisation avec élimination de l'élément rapporté.

### Description détaillée

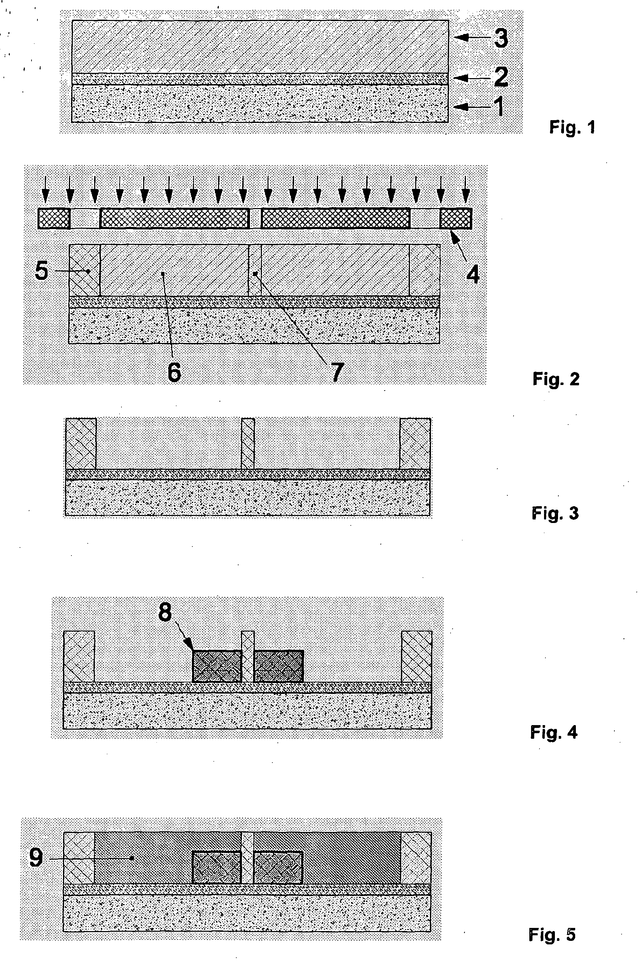

Selon la figure 1, le substrat 1 est généralement une plaque de verre, de Silicium ou de métal sur laquelle est déposée une couche conductrice 2 réalisée par exemple par une évaporation de chrome et d'or. Sur cette couche conductrice est déposée puis séchée une couche photorésist 3 sensible aux rayons ultraviolets (ou aux rayons X selon la technologie choisie).

Cette couche est ensuite irradiée par une source à ultraviolets à travers une plaque en verre sur laquelle a été structuré un motif en chrome. Cette plaque avec sa découpe de chrome est appelée un photomasque 4 illustré à la figure 2.

La lumière arrivant parfaitement perpendiculairement sur le photomasque 4, seules les portions de photorésist non protégées 5, 7 par le motif en chrome seront irradiées.

Dans la cas particulier d'une résine négative comme par exemple le SU8, un recuit de la couche de photorésist provoque la polymérisation dans les zones ayant reçu le rayonnement UV. Cette partie polymérisée devient insensible à la plupart des solvants par opposition aux autres zones 6 qui sont dissoutes par un solvant.

On obtient ainsi la structure de la figure 3 avec les régions polymérisées se développant sur le substrat et dont l'épaisseur égale la couche de photorésist déposée initialement. La forme est définie par le premier photomasque 4. Certaines portions de cette couche polymérisée vont servir de guide à un élément rapporté 8. Ce guidage peut être soit par la partie extérieure de l'élément rapporté, soit par un orifice dudit élément comme représenté à la figure 4, soit une combinaison des deux. La figure 4 illustre le moule avec l'insert 8 placé à l'intérieur.

L'étape suivante consiste à déposer du métal par électroformage pour former un bloc métallique 9 épousant les structures polymérisées tel que représenté à la figure 5 et enserrant l'élément rapporté 8.

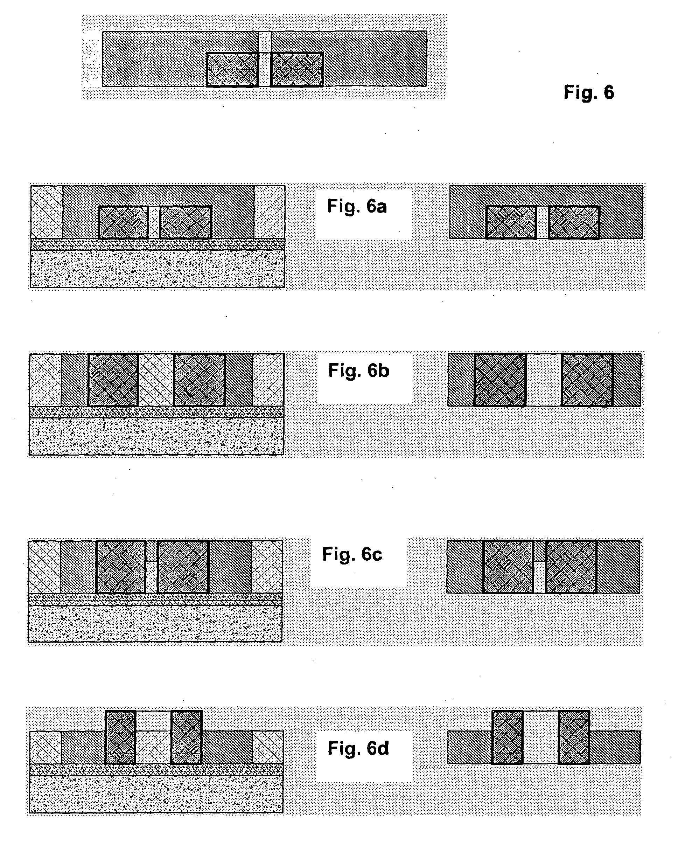

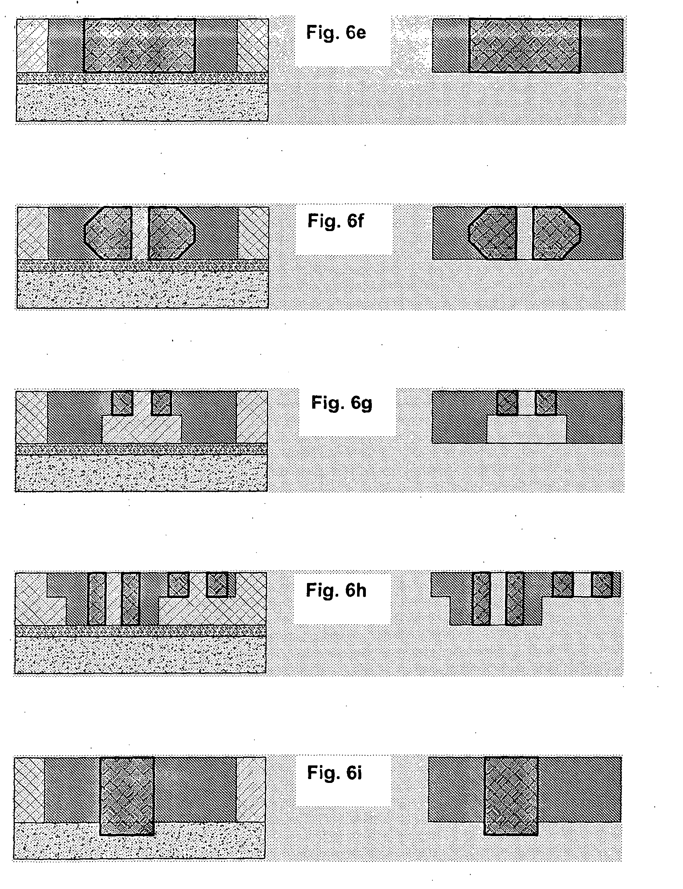

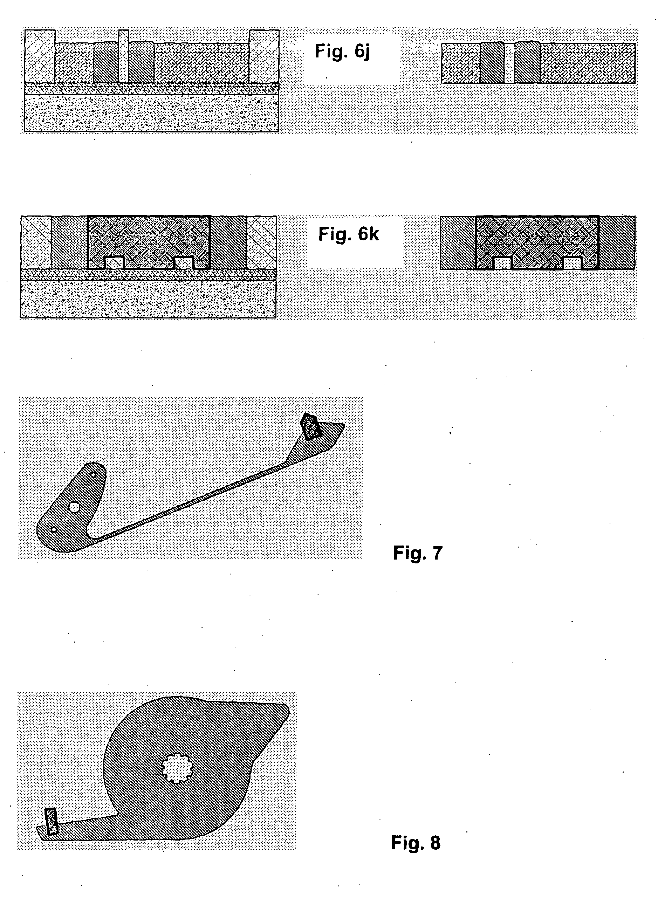

La dernière étape consiste à libérer le bloc métallique 9 et à éliminer le moule de photoresist polymérisé pour obtenir la pièce de la figure 6.

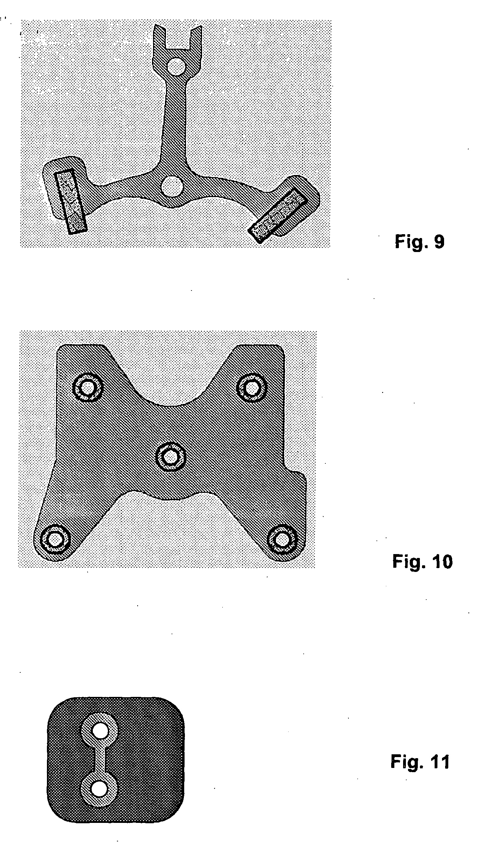

Ainsi on obtient une pièce directement sortie du moule et comprenant l'élément rapporté qui fait corps avec les parties métalliques formées par l'électroformage. Il n'y a plus de tolérance entre la pièce métallique et l'insert (élément rapporté) car le positionnement de ce dernier est assuré par le moule en photoresist lui-même. Lors de l'opération de dépose des parties métalliques, ces dernières vont épouser le ou les flancs de l'insert et créer ainsi une liaison intime avec l'insert. Par "flanc" il est fait référence aux parois de l'insert sans contact avec le moule et donc englobant également les ouvertures telles qu'illustrées à la figure 11. Le grand avantage de cette méthode est d'être insensible aux dimensions extérieures de l'insert qui n'a plus besoin d'être réalisé avec grande précision. Contrairement à la méthode appliquée jusqu'alors, dans laquelle l'insert était chassé dans un orifice de la pièce métallique et donc devait être d'une grande précision.

Selon une variante de réalisation, le substrat ne comprend pas de couche conductrice initiale, la couche conductrice étant déposée sur le substrat d'une manière sélective (grâce à un masque) au moins dans les régions où le photoresist sera éliminé. Une partie de ce dépôt conducteur va également permettre de relier toutes les portions ensemble et vers l'extérieur du moule afin d'assurer la connexion électrique nécessaire lors de l'opération d'électroformage.

L'élément rapporté peut être de différentes matières telles que céramique, plastique, verre, silicium, pierre taillée par exemple. Dans le cas de pose d'un élément rapporté réalisé en un matériau conducteur, une étape de dépose d'une couche isolante sur l'élément rapporté peut être réalisé telle que par exemple une laque. Cette opération peut être effectuée soit avant la dépose de l'insert dans le moule, soit postérieurement, par dépôt sélectif grâce à un masque chablon. Un autre moyen d'isoler l'insert est l'application d'une sous-couche de photoresist mince sur le substrat et la polymériser au moins à l'endroit ou va se trouver l'insert. Cette opération précède le dépôt du photoresist qui formera le moule. Il est à noter que cette sous-couche peut également être polymérisée là où se trouvera le photoresist polymérisé (5, et 7 sur la figure 2) du moule.

Cet élément rapporté est de préférence chassé sur la partie de photoresist lui servant de guide afin de minimiser l'espace entre la résine photoresist et l'élément rapporté. Néanmoins si des parties métalliques devaient se déposer sur le substrat entre l'élément rapporté et le photoresist, ces parties seraient facilement nettoyées lors de la séparation de la pièce du substrat, ces parties n'adhérant à aucune parties métalliques de la pièce elle-même.

Les différentes figures 6 illustrent des variantes de réalisation de l'invention. La figure 6a est une exécution avec un moule à deux niveaux c'est à dire l'utilisation d'un premier masque pour le niveau inférieur correspondant au guidage de l'insert et un second masque pour le moule final de la pièce métallique. Selon les besoins, une opération de polissage de la pièce finale peut être faite pour obtenir une surface plane. La pièce finale comporte ainsi un trou borgne ou une fente ou toute autre forme fermée. Comme exemple de réalisation, l'insert est un écrou à filetage fin. Une vis sera introduite dans l'insert et viendra buter sur la partie métallique lorsqu'elle aura terminé sa course. La réalisation d'une telle pièce de manière conventionnelle pose de gros problèmes car il faudrait réaliser un trou borgne puis le fileter. Une telle opération sur des pièces de moins d'un millimètre d'épaisseur reste très difficile.

Les exemples des figures 6a à 6h sont caractéristiques de l'incrustation de pierres ou autre éléments axiaux. Un pont de forme quelconque va comprendre plusieurs pierres supportant les axes. Dans la pratique, l'insert aura de préférence une forme de chanfrein en haut et en bas afin que de lors de la croissance du métal le long de l'insert, il vienne emprisonner l'insert et l'empêcher de sortir de son logement. On peut imaginer que pour renforcer cet effet d'emprisonnement, l'insert aie un pourtour en forme de V, négatif ou positif assurant une grande liaison entre ledit insert et la partie métallique tel qu'illustré à la figure 6f.

Le mode de réalisation de la figure 6d montre comment on peut faire varier les différentes épaisseurs des éléments constituants la pièce. Dans le cas illustré, la couche métallique apportée par électroformage est d'une épaisseur inférieure à l'insert. Les combinaisons de réalisation sont nombreuses et l'insert au lieu de disposer d'une ouverture pourrait constituer un axe ou un pallier (en bronze par exemple) qui s'étend perpendiculairement par rapport au plan de la pièce.

L'insert de la figure 6e est guidé par ses flancs extérieurs, il n'est pas nécessaire de disposer d'un axe sur lequel l'insert viendrait se glisser. Dans cette coupe, la partie métallique arrive contre l'insert et pour son positionnement, d'autres parties de photoresist non représentées ont été nécessaires pour positionner l'insert dans le moule. Le cas de la figure 6f est identique à celui représenté à la figure 6b; la partie évidée de l'insert étant chassée sur le moule avant l'opération de métallisation. Par contre il a été illustré de manière notoire la forme de chanfrein de l'insert afin que l'effet d'enserrement de l'insert soit mis en évidence. Dans la pratique, un chanfrein ou une autre forme de plus faible amplitude sera utilisé car l'effet de champignonage permet de manière limitée à la couche métallique de s'étendre latéralement.

La variante de la figure 6g illustre un moule à 2 niveaux dans lequel l'insert est placé au second niveau. Deux déposes de photoresist et irradiation sont nécessaires pour la réalisation d'une telle pièce.

De même que pour la pièce illustrée à la figure 6h, les deux niveaux du moule sont exploités pour placer des inserts à deux niveaux différents. Le moule multi-niveaux est tout d'abord réalisé et les deux inserts sont placés chacun à son niveau. On voit ici toute la souplesse qu'offre ce procédé.

La figure 6i illustre un mode similaire au procédé de l'invention faisant appel à une opération préalable d'usinage du substrat, pour placer l'insert.

Dans le cas illustré par la figure 6j, la croissance métallique se fait à l'intérieur de l'insert. L'insert définit les limites extérieures de la pièce finie et la partie métallique est intégrée à l'intérieur de l'insert. Le matériau utilisé pour l'insert est ici du silicium dans lequel des parties métalliques seront déposées par électroformage. Un exemple similaire est illustré à la figure 11 dans laquelle la partie métallique forme une forme de lunette.

La figure 6k illustre le cas où l'insert est tenu par une partie évidée qui est faite uniquement pour le maintien de l'insert dans le moule.

Les figures 7 à 11 illustrent des exemples de réalisation de pièces terminées. La partie grisée est réalisée par dépôt de métal sur le substrat alors que la partie sombre représente l'insert. On remarquera que la partie métallique n'enserre pas nécessairement l'insert. Il suffit qu'une partie de l'insert soit reliée à la partie métallique pour assurer la maintien de l'insert dans la partie métallique. La figure 6e illustre une coupe au niveau de la pièce de la figure 7 dans la partie métallique. Le photoresist viendra entourer la partie de l'insert sans contact avec la partie métallique et assurera son positionnement exact. Dans cet exemple, la longueur de l'insert n'a pas d'importance puisque que c'est la partie en contact avec le photoresist qui déterminera la position finale de la partie en forme de V de l'insert. Dans le cas d'un insert plus court, la partie métallique va enserrer l'insert quelque soit sa longueur.

Dans les exemples des figures 7 à 9, l'insert aura de préférence une surface non lisse en contact avec la partie métallique, par exemple par la présence de rainures. Ceci afin d'assurer une bonne liaison entre l'insert et la partie métallique.

L'exemple de la figure 10 montre un pont sur lequel a été placé 5 pierres pour la formation d'axes. On voit ici tout l'avantage de l'invention qui permet de fournir une pièce finie avec les 5 pierres placées avec une précision inégalée. Pour rappel, le photoresist définit l'axe des pierres et la précision finale entre deux axes est définie par le masque d'irradiation du photoresist. Aucune autre tolérance ne vient s'additionner à celle du masque.

La figure 11 illustre un exemple dans lequel l'insert constitue la partie principale de la pièce. Des ouvertures dans l'insert vont accueillir la métallisation sauf où des parties de moule, ici en forme de cylindre interdiront à la métallisation de se déposer.

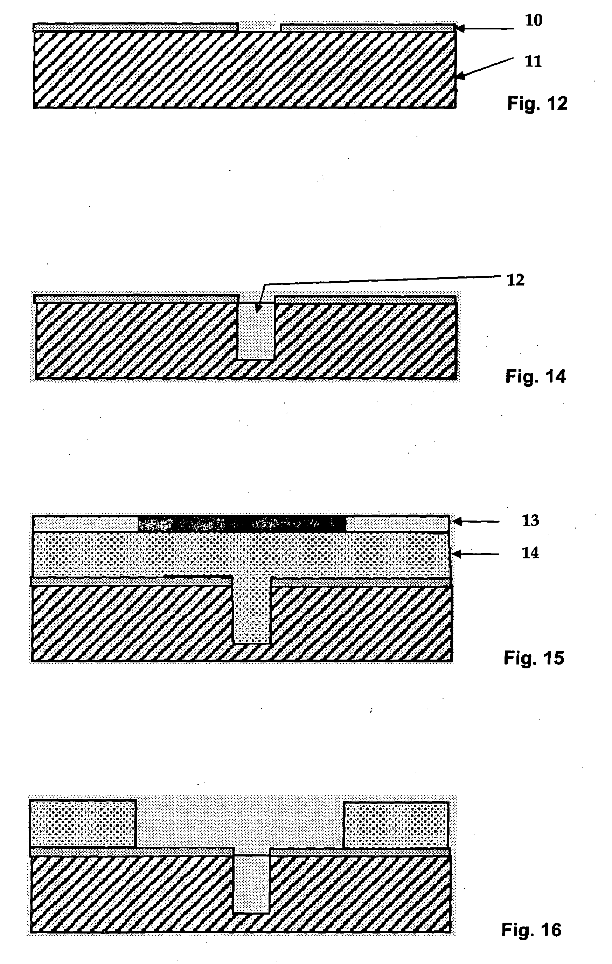

La figure 12 illustre une autre application similaire du procédé de l'invention. Sur un substrat 11 de verre ou de Silicium, on dépose une couche de photoresist 10 qui est sélectivement dissoute pour laisser l'accès au substrat pour l'opération suivante.

Cette opération consiste à une gravure du substrat par des techniques connues telles que la technique "Deep Reactive Ion Etching" développée par Bosch qui permet d'attaquer le substrat aux endroits laissés libre par le photoresist. Dans notre exemple, cette attaque permet de former un orifice 12.

L'étape suivante est la dépose d'une couche de photoresist épais 14. Un masque 13 est appliqué pour une polymérisation sélective. Le photoresist non polymérisé est ensuite dissous tel qu'illustré à la figure 16 laissant apparaître l'orifice dans le substrat.

On place ensuite dans l'orifice un élément rapporté 15 illustré ici par un goujon. Il est maintenu en place grâce à l'orifice dans le substrat. On applique ensuite une opération d'électroformage pour le dépôt de parties métalliques tout autour de l'élément rapporté (illustré par la référence 16). La pièce ainsi réalisée est séparée du substrat avec l'insert. Ce dernier est ensuite enlevé, soit par des moyens chimiques, soit par des moyens mécaniques. Dans le premier cas, la dissolution de fera préférence en utilisant un couple solvant-plastique dont le solvant est capable de dissoudre ce dernier, par exemple l'acétone dissout le PE). Dans le second cas, on choisira un insert avec des propriétés plastiques (déformation). Pour favoriser la déformation on peut utiliser un insert avec un trou dans le sens du filetage. La paroi de l'insert sera ainsi très mince.

Le même résultat peut être obtenu sans le gravage d'un orifice dans le substrat avec une autre application du procédé de l'invention. Ceci est possible par la fabrication d'un moule en photoresist à deux niveaux. Le premier niveau (en contact avec le substrat) aura la forme de l'orifice et a pour fonction de maintenir l'insert dans sa position. En lieu et place d'un orifice, le premier niveau du moule photoresist . Le second niveau sera de la forme de la pièce métallique qui entoure l'insert.

Grâce à cette méthode, on pourra obtenir des pièces de formes complexes en plan avec les filetages nécessaires directement fabriqués avec ladite pièce perpendiculairement audit plan.

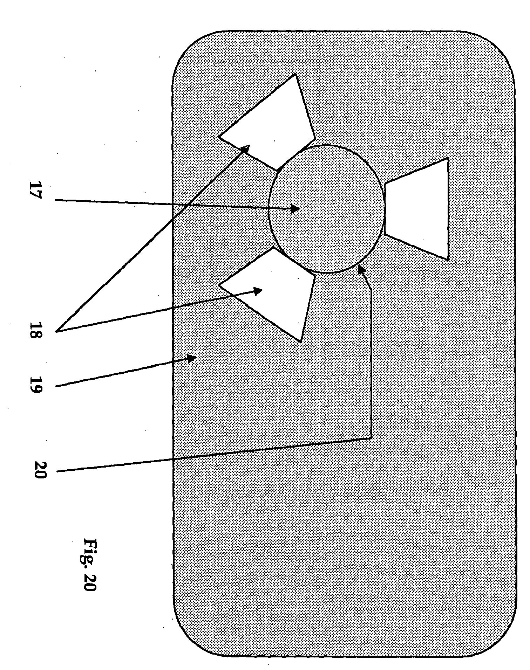

Sur la figure 20 est illustré une autre forme de réalisation de filetage utilisant une seule couche de photoresist et aucune gravure dans le substrat. Le photoresist 18 ne va pas entourer l'insert fileté 17 complètement mais partiellement, juste suffisamment pour maintenir l'insert en position lors de l'électroformage. Ainsi le métal 19 va croitre le long des parois de l'insert aux endroits 20 qui se sont pas en contact avec le moule. Le filetage obtenu en final sera discontinu mais suffisant pour qu'une vis puisse y être insérée.

Que ce soit pour la solution à un ou deux niveaux, le goujon peut être maintenu dans sa position avant l'électroformage par une protubérance du moule qui servira de guide à un goujon creux. Le goujon est percé (au moins partiellement, il n'est pas nécessaire que le trou soit traversant) et le moule de photoresist forme un pilier sur lequel vient se glisser le goujon. Ainsi les parties métalliques de l'électroformage vont recouvrir toute la surface extérieure du goujon et former le filetage souhaité. La partie du moule ayant servi au maintien du goujon est éliminée avec le reste du moule. Le goujon est également éliminé selon l'un des modes décrits plus haut.

## Revendications

1. Méthode de fabrication de pièces nécessitant au moins l'assemblage de deux éléments, l'un obtenu par photolithographie et électroformage, et l'autre par un autre procédé de fabrication, cette méthode comprenant les étapes suivantes :
- irradiation au travers d'un premier photomasque (4), d'une première couche de photorésist (3) appliquée sur un substrat (1) définissant un premier niveau,
- polymérisation de la première couche de photorésist et élimination de la couche de photorésist non polymérisée (6, 7), la partie de photoresist restante constituant le moule photoresist (5,7),
- placement d'un élément rapporté (8) obtenu par un autre procédé de fabrication dans le moule photoresist (5, 7),
- dépôt d'un couche métallique (9) par électroformage sur le substrat de sorte que la croissance de la couche métallique (9) enserre tout ou partie de l'élément rapporté (8),
- obtention de la pièce par séparation du substrat (1) d'avec la couche métallique électroformée solidaire de l'élément rapporté (8) et élimination du moule photorésist (5, 7)
**caractérisée en ce que** ledit moule de photorésist sert de guide à l'élément rapporté.

2. Méthode selon la revendication 1, **caractérisée en ce que** l'élément rapporté (8) dispose d'une ouverture de forme identique à au moins une partie du moule photoresist (7), ledit élément étant chassé dans la partie correspondante du moule afin que l'ouverture de l'élément rapporté soit obstruée par la partie correspondante du moule photoresist.

3. Méthode selon la revendication 1, **caractérisée en ce que** l'élément rapporté (8) est plein, le moule photoresist (5) comprenant une partie destinée à enserrer tout ou partie de l'élément rapporté, ce dernier étant placé dans le logement du moule photoresist correspondant.

4. Méthode selon l'une des revendications 1 à 3, **caractérisée en ce que** le moule photoresist est réalisé selon deux niveaux grâce au premier photomasque et à un second photomasque, l'élément rapporté (8) étant maintenu dans sa position grâce au moule photoresist du premier niveau, les contours de la pièce étant délimités par rapport au moule photoresist du premier et second niveau.

5. Méthode selon l'une des revendications 1 à 3, **caractérisée en ce que** le moule photoresist est réalisé selon deux niveaux grâce au premier photomasque et à un second photomasque, l'élément rapporté (8) étant maintenu dans sa position grâce au moule photoresist du second niveau, la pièce étant délimitée par rapport au moule photoresist du premier et second niveau.

6. Méthode selon l'une des revendications 1 à 3, **caractérisée en ce que** le moule photoresist est réalisé selon deux niveaux grâce au premier photomasque et à un second photomasque, un premier élément rapporté étant maintenu dans sa position grâce au moule photoresist du premier niveau, un second élément rapporté étant maintenu dans sa position grâce au moule photoresist de second niveau, la pièce étant délimitée par rapport au moule photoresist du premier et second niveau.

7. Méthode selon l'une des revendications 1 à 6, **caractérisée en ce que** l'élément rapporté (8) est dans un matériau conducteur et **en ce qu'**elle comprend une étape de dépose d'une couche isolante sur ledit élément rapporté (8) préalablement ou postérieurement à son placement dans le moule photoresist.

8. Méthode selon l'une des revendications 1 à 6, **caractérisée en ce qu'**elle comprend, préalablement au dépôt de la couche photoresist, une opération de dépose d'une sous-couche de photoresist, polymérisation de ladite sous-couche au moins à l'endroit destiné à recevoir l'élément rapporté (8) afin d'assurer une couche isolante à cet endroit.

9. Méthode selon l'une des revendications 1 à 6, **caractérisée en ce** l'élément rapporté (8) définit les limites extérieures de la pièce, la couche métallique étant formée à l'intérieur d'au moins un évidemment de l'élément rapporté (8).

10. Méthode selon l'une des revendications 1 à 3, **caractérisée en ce que** l'élément rapporté (8) est fileté sur sa surface extérieure et au moins partiellement creux, et **en ce que** le moule photoresist (5, 7) définit une forme adaptée au creux de l'élément rapporté de sorte que l'élément rapporté (5) s'emboite sur la partie correspondante du moule, cette méthode comprenant de plus une opération d'élimination de l'élément rapporté, la partie métallique en contact avec l'élément rapporté définissant un filetage.

11. Méthode selon l'une des revendications 1 à 3, **caractérisée en ce que** l'élément rapporté (8) comprend un filetage et **en ce que** le moule photoresist (5, 7) entoure partiellement l'élément rapporté, de sorte que la couche métallique soit partiellement en contact avec l'élément rapporté (8), cette méthode comprenant de plus une opération d'élimination de l'élément rapporté, la partie métallique en contact avec l'élément rapporté définissant un filetage.

12. Méthode selon l'une des revendications 1 à 3, **caractérisée en ce que** le moule photoresist (5, 7) est réalisé selon deux niveaux grâce au premier photomasque et à un second photomasque, l'élément rapporté (8) étant maintenu dans sa position grâce au moule photoresist du premier niveau, le second niveau définissant le pourtour de la pièce, cette méthode comprenant de plus une opération d'élimination de l'élément rapporté, la forme extérieure de l'élément rapporté définissant le profil des parois intérieures correspondantes de la pièce.

13. Pièce composée de deux éléments, soit un premier élément composé par une partie métallique (9) obtenue par photolithographie, grâce à un moule de photoresist, et par électroformage, et un second élément composé d'un ou plusieurs éléments rapportés (8) obtenu par un autre procédé de fabrication et comprenant au moins un flanc en contact avec la partie métallique (9), la liaison entre l'élément rapporté (8) et la partie métallique (9) est dite intime résultant de la croissance de la partie métallique le long du flanc de l'élément rapporté (8), tout ou partie des deux faces de la pièce sont constituées par la partie métallique (9), et **caractérisée en ce que** le ou les éléments rapportés sont guidés par le moule de photoresist.

14. Pièce selon la revendication 13, **caractérisé en ce que** les flancs présentent des rugosités, la partie métallique (9) épousant intimement la rugosité desdits flancs de l'élément rapporté (8).

15. Pièce selon la revendication 13 ou 14, **caractérisée en ce que** l'élément rapporté (8) comprend des flancs sans contact avec la partie métallique (9).

16. Pièce selon les revendications 13 à 15, **caractérisée en ce que** l'élément rapporté (8) est en plastique, en céramique, en verre ou en métal ou matériau semi-conducteur.

## Claims

1. Method of manufacturing pieces requiring at least the assembling of two elements, one obtained by photolithography and electroforming, and the other by another manufacturing process, this method comprising the following steps:
- irradiation through a first photo mask (4) of a first photoresist layer (3) applied on a substrate (1) defining a first level,
- polymerization of the first photoresist layer and elimination of the photoresist layer which is not polymerized (6, 7), the remaining part of photoresist forming the photoresist mould (5,7),
- positioning an add-in element (8) obtained through another manufacturing process in the photoresist mould (5, 7),
- deposit of a metallic layer (9) by electroforming on the substrate in such a way that the growth of the metallic layer (9) totally or partially encloses the add-in element (8),
- getting the piece by separation of the substrate (1) from the electro-formed metallic layer integral with the add-in element (8) and elimination of the photoresist mould (5, 7),
- **characterized in that** said photoresist mould is used as a guide for the add-in element.

2. Method according to claim 1, **characterized in that** the add-in element (8) has an opening shaped identically to at least one part of the photoresist mould (7), said element being fitted in the corresponding part of the mould so that the opening of the add-in element is obstructed by the corresponding part of the photoresist mould.

3. Method according to claim 1, **characterized in that** the add-in element (8) is solid, the photoresist mould (5) comprising a part intended to grip tightly, totally or partially, the add-in element, the latter being placed in the housing of the corresponding photoresist mould.

4. Method according to one of the claims 1 to 3, **characterized in that** the photoresist mould is made according to two levels thanks to the first photo mask and to a second photo mask, the add-in element (8) being maintained in position thanks to the photoresist mould of the first level, the outlines of the piece being delimited in relation to the photoresist mould of the first and second level.

5. Method according to one of the claims 1 to 3, **characterized in that** the photoresist mould is made according to two levels thanks to the first photo mask and to a second photo mask, the add-in element (8) being maintained in position thanks to the photoresist mould of the second level, the piece being delimited in relation to the photoresist mould of the first and second level.

6. Method according to one of the claims 1 to 3, **characterized in that** the photoresist mould is made according to two levels thanks to the first photo mask and to a second photo mask, a first add-in element being maintained in position thanks to the photoresist mould of the first level, a second add-in element being maintained in position thanks to the photoresist mould of the second level, the piece being delimited in relation to the photoresist mould of the first and second level.

7. Method according to one of the claims 1 to 6, **characterized in that** the add-in element (8) is made of conductive material and **in that** it includes the step of applying an insulating layer on said add-in element (8) before or after its positioning in the photoresist mould.

8. Method according to one of the claims 1 to 6, **characterized in that** it includes, before the deposit of the photoresist layer, the operation of the deposit of a photoresist underlayer, the polymerization of said underlayer at least at the spot intended to receive the add-in element (8) in order to ensure an insulating layer at this spot.

9. Method according to one of the claims 1 to 6, **characterized in that** the add-in element (8) defines the outer limits of the piece, the metallic layer being formed inside at least one groove of the add-in element (8).

10. Method according to one of the claims 1 to 3, **characterized in that** the add-in element (8) is threaded on its external surface and is at least partially hollow, and **in that** the photoresist mould (5, 7) defines an adapted form to the hollow of the add-in element in such a way that the add-in element (5) fits into the corresponding part of the mould, this method comprising moreover the operation of eliminating the add-in element, the metallic part in contact with the add-in element defining a thread.

11. Method according to one of the claims 1 to 3, **characterized in that** the add-in element (8) includes a thread and **in that** the photoresist mould (5, 7) partially surrounds the add-in element, in such a way that the metallic layer is partially in contact with the add-in element (8), this method comprising moreover the operation of eliminating the add-in element, the metallic part in contact with the add-in element defining a thread.

12. Method according to one of the claims 1 to 3, **characterized in that** the photoresist mould (5, 7) is made according to two levels thanks to the first photo mask and to a second photo mask, the add-in element (8) being maintained in position thanks to the photoresist mould of the first level, the second level defining the periphery of the piece, this method comprising moreover the operation of eliminating the add-in element, the external form of the add-in element defining the profile of the corresponding inner walls of the piece.

13. Piece made up of two elements, a first element made up of a metallic part (9) obtained by photolithography, thanks to a photoresist mould, and by electroforming, and a second element made up of one or more add-in elements (8) obtained through another manufacturing process and comprising at least one side in contact with the metallic part (9), the connection between the add-in element (8) and the metallic part (9) is called intimate and results from the growth of the metallic part along the side of the add-in element (8), the whole or part of the two sides of the piece are formed by the metallic part (9), and **characterized in that** the add-in elements are guided by the photoresist mould.

14. Piece according to claim 13, **characterized in that** the sides have rough spots, the metallic part (9) intimately fitting the roughness of said sides of the add-in element (8).

15. Piece according to claim 13 or 14, **characterized in that** the add-in element (8) includes sides without any contact with the metallic part (9).

16. Piece according to claims 13 to 15, **characterized in that** the add-in element (8) is of plastic material, of ceramics, of glass or of metal or of semiconductor material.

## Patentansprüche

1. Verfahren zum Herstellen von Teilen, die wenigstens den Zusammenbau von zwei Elementen erfordern, wobei das eine durch Fotolithographie sowie Elektroformung und das andere durch ein anderes Herstellungsverfahren bereitgestellt worden ist, wobei das Verfahren die folgenden Schritte aufweist:
- durch eine erste Fotomaske (4) Bestrahlen einer ersten Fotolackschicht (3), die auf einem Substrat (1) aufgebracht ist und ein erstes Niveau bildet,
- Polymerisation der ersten Fotolackschicht und Beseitigen der nicht polymerisierten Fotolackschicht (6, 7), wobei der verbleibende Teil des Fotolacks eine Fotolackform (5, 7) bildet,
- Anordnen eines Einsatzelementes (8), das durch ein anderes Herstellungsverfahren bereitgestellt worden ist, in der Fotolackform (5, 7),
- Abscheiden einer Metallschicht (9) durch Elektroformung auf dem Substrat derart, dass das Wachstum der Metallschicht (9) das Einsatzelement (8) ganz oder teilweise umschließt,
- Erhalt des Teiles durch Trennen des Substrats (1) von der durch Elektroformung hergestellten, mit dem Einsatzelement (8) einstückigen Metallschicht und Beseitigen der Fotolackform (5, 7),
- **dadurch gekennzeichnet, dass** die Fotolackform zum Führen des Einsatzelementes dient.

2. Verfahren nach Anspruch 1, **dadurch gekennzeichnet, dass** das Einsatzelement (8) über eine Öffnung mit einer zu wenigstens einem Teil der Fotolackform (7) identischen Gestalt verfügt, wobei das Element in den zugehörigen Teil der Form verbracht ist, so dass die Öffnung des Einsatzelementes durch den entsprechenden Teil der Fotolackform ausgefüllt ist.

3. Verfahren nach Anspruch 1, **dadurch gekennzeichnet, dass** das Einsatzelement (8) massiv ist, wobei die Fotolackform (5) über einen Teil verfügt, der dazu bestimmt ist, das Einsatzelement ganz oder teilweise zu umschließen, wobei dieses in der zugeordneten Aufnahme der Fotolackform angeordnet ist.

4. Verfahren nach einem der Ansprüche 1 bis 3, **dadurch gekennzeichnet, dass** die Fotolackform bedingt durch eine erste Fotomaske und eine zweite Fotomaske in zwei Niveaus ausgeführt ist, wobei das Einsatzelement (8) aufgrund der Fotolackform des ersten Niveaus in Position gehalten wird, wobei die Umrandungen des Teiles durch das erste Niveau und das zweite Niveau der Fotolackform begrenzt sind.

5. Verfahren nach einem der Ansprüche 1 bis 3, **dadurch gekennzeichnet, dass** die Fotolackform bedingt durch eine erste Fotomaske und eine zweite Fotomaske in zwei Niveaus ausgeführt ist, wobei das Einsatzelement (8) aufgrund der Fotolackform des zweiten Niveaus in Position gehalten wird, wobei das Teil durch das erste Niveau und das zweite Niveau der Fotolackform begrenzt ist.

6. Verfahren nach einem der Ansprüche 1 bis 3, **dadurch gekennzeichnet, dass** die Fotolackform bedingt durch eine erste Fotomaske und eine zweite Fotomaske in zwei Niveaus ausgeführt ist, wobei ein erstes Einsatzelement aufgrund der Fotolackform des ersten Niveaus in Position gehalten wird, wobei ein zweites Einsatzelement aufgrund der Fotolackform des zweiten Niveaus in Position gehalten wird, wobei das Teil durch das erste Niveau und das zweite Niveau der Fotolackform begrenzt ist.

7. Verfahren nach einem der Ansprüche 1 bis 6, **dadurch gekennzeichnet, dass** das Einsatzelement (8) aus einem leitenden Element ist und dass das Verfahren einen Schritt des Abscheidens einer Isolierschicht auf dem Einsatzelement (8) vor oder nach dessen Anordnen in der Fotolackform aufweist.

8. Verfahren nach einem der Ansprüche 1 bis 6, **dadurch gekennzeichnet, dass** es vor dem Aufbringen der Fotolackschicht den Vorgang des Aufbringens einer Unterfotolackschicht, Polymerisation dieser Unterschicht an wenigstens der Stelle aufweist, die dazu bestimmt ist, das Einsatzelement (8) aufzunehmen, um an dieser Stelle eine Isolierschicht sicherzustellen.

9. Verfahren nach einem der Ansprüche 1 bis 6, **dadurch gekennzeichnet, dass** das Einsatzelement (8) die äußeren Begrenzungen des Teiles bildet, wobei die Metallschicht im Inneren wenigstens einer Ausnehmung des Einsatzelementes (8) ausgebildet ist.

10. Verfahren nach einem der Ansprüche 1 bis 3, **dadurch gekennzeichnet, dass** das Einsatzelement (8) an seiner äußeren Oberfläche mit einem Gewinde versehen sowie wenigstens teilweise hohl ist und dass die Fotolackform (5, 7) eine an den Hohlraum des Einsatzelementes angepasste Form aufweist, so dass sich das Einsatzelement (5) in den zugeordneten Bereich der Form einfügt, wobei dieses Verfahren weiterhin einen Vorgang des Beseitigens des Einsatzelementes aufweist, wobei der in Kontakt mit dem Einsatzelement befindliche Metallbereich ein Gewinde bildet.

11. Verfahren nach einem der Ansprüche 1 bis 8, **dadurch gekennzeichnet, dass** das Einsatzteil (8) über ein Gewinde verfügt und dass die Fotolackform (5, 7) teilweise das Einsatzelement umgibt, so dass die Metallschicht teilweise mit dem Einsatzelement (8) in Kontakt ist, wobei das Verfahren weiterhin einen Vorgang des Beseitigens des Einsatzelementes aufweist, wobei der in Kontakt mit dem Einsatzelement befindliche Metallbereich ein Gewinde bildet.

12. Verfahren nach einem der Ansprüche 1 bis 3, **dadurch gekennzeichnet, dass** die Fotolackform (5, 7) aufgrund der ersten Fotomaske und einer zweiten Fotomaske in zwei Niveaus ausgeführt ist, wobei das Einsatzelement (8) aufgrund der Fotolackform des ersten Niveaus in Position gehalten wird, wobei das zweite Niveau die Umrandung des Teiles bildet, wobei das Verfahren weiterhin einen Vorgang des Beseitigens des Einsatzteiles aufweist, wobei die äußere Form des Einsatzteiles das Profil der zugeordneten Wände des Teiles bildet.

13. Teil, das aus zwei Elementen zusammengesetzt ist, nämlich aus einem ersten Element, das aus einem durch Fotolithographie auf der Grundlage einer Fotolackform und durch Elektroformung erhaltenes Metallstück (9) und aus einem zweiten Element, das aus einem oder mehreren Einsatzelementen (8) gebildet ist, das beziehungsweise die durch ein anderes Herstellungsverfahren bereit gestellt ist beziehungsweise sind, und das wenigstens eine in Kontakt mit dem Metallstück (9) stehende Seite aufweist, wobei die Verbindung zwischen dem Einsatzelement (8) und dem Metallstück (9) innig ist, was sich aus dem Wachstum des Metallstückes entlang der Seite des Einsatzelementes (8) ergibt, wobei die beiden Seiten des Teiles ganz oder teilweise durch das Metallstück (9) gebildet sind, und **dadurch gekennzeichnet, dass** das Einsatzelement beziehungsweise die Einsatzelemente durch die Fotolackform geführt ist beziehungsweise sind.

14. Teil nach Anspruch 13, **dadurch gekennzeichnet, dass** die Seiten Rauhigkeiten aufweisen, wobei sich das Metallstück (9) innig an die Rauhigkeit der Seiten des Einsatzelementes (8) anpasst.

15. Teil nach Anspruch 13 oder 14, **dadurch gekennzeichnet, dass** das Einsatzelement (8) über Seiten verfügt, die mit dem Metallstück (9) kontaktfrei sind.

16. Teil nach einem der Ansprüche 13 bis 15, **dadurch gekennzeichnet, dass** das Einsatzelement (8) aus Kunststoff, aus Keramik, aus Glas, aus Metall oder einem Halbleitermaterial ist.
